(19) Europäisches Patentamt
European Patent Office
Office européen des brevets

(11) Numéro de publication: **0 178 955**
**A1**

(12) # DEMANDE DE BREVET EUROPEEN

(21) Numéro de dépôt: 85401632.6

(22) Date de dépôt: 12.08.85

(51) Int. Cl.[4]: C 23 C 18/00
H 01 L 21/368

(30) Priorité: 23.08.84 FR 8413118

(43) Date de publication de la demande: 23.04.86 Bulletin 86/17

(84) Etats contractants désignés: AT CH DE GB IT LI NL

(71) Demandeur: COMMISSARIAT A L'ENERGIE ATOMIQUE
Etablissement de Caractère Scientifique Technique et Industriel
31/33, rue de la Fédération
F-75015 Paris(FR)

(72) Inventeur: Nicolau, Yann Florent
Le Brinchet Cidex 634
F-38330 Saint Nazaire Les Eymes(FR)

(74) Mandataire: Mongrédien, André et al,
c/o BREVATOME 25, rue de Ponthieu
F-75008 Paris(FR)

(54) **Procédé et dispositif de dépôt sur un substrat d'une couche mince d'un composé comportant au moins un constituant cationique et au moins un constituant anionique.**

(57) L'invention a pour objet un procédé de dépôt sur un substrat d'une couche mince d'un composé comportant au moins un constituant cationique C et au moins un constituant anionique A, tel que du sulfure de zinc.

On forme sur le substrat (11) au moins deux couches ioniques superposées comportant respectivement le ou lesdits constituants cationiques C et le ou lesdits constituants anioniques A par immersions successives du substrat dans une première solution (3) contenant par example un sel de C tel que du sulfate de zinc et dans une deuxième solution (3') contenant par exemple un sel de A tel que du sulfure de sodium, en effectuant un rinçage du substrat (en 5) entre deux immersions.

./...

EP 0 178 955 A1

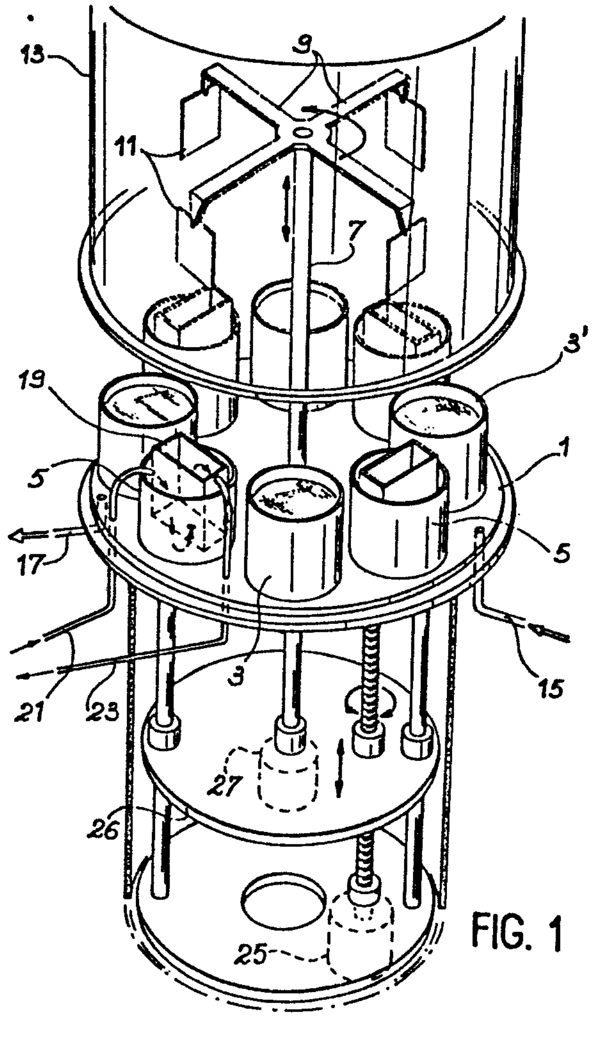

FIG. 1

# PROCEDE ET DISPOSITIF DE DEPOT SUR UN SUBSTRAT D'UNE COUCHE MINCE D'UN COMPOSE COMPORTANT AU MOINS UN CONSTITUANT CATIONIQUE ET AU MOINS UN CONSTITUANT ANIONIQUE

La présente invention a pour objet un procédé et un dispositif de dépôt sur un substrat d'une couche mince d'un composé comportant au moins un constituant cationique et au moins un constituant anionique.

De façon plus précise, elle concerne un procédé de dépôt de couches compactes, monocristallines ou polycristallines, exemptes de défauts, de composition stochiométrique et d'épaisseur homogène, susceptibles d'être utilisées pour la réalisation de diodes et d'écrans électroluminescents, de batteries solaires et de composants pour l'optoélectronique, la détection infrarouge et l'enregistrement magnétique. Elle s'applique en particulier au dépôt de composés de formule $C_mA_n$ dans laquelle C représente un cation, A représente un anion qui peut être un oxyanion ou un polyoxyanion, m est la valence de l'anion et n est la valence du cation.

Parmi les procédés connus actuellement pour déposer sur un substrat des couches minces monocristallines ou polycristallines, on peut distinguer les procédés faisant appel aux techniques de dépôt en phase vapeur et aux techniques de dépôt en solution.

Les techniques de dépôt en phase vapeur comprennent les procédés de dépôt sous vide par évaporation thermique ou par bombardement électronique, par pulvérisation cathodique, par pyrolyse, ou par décomposition chimique (CVD) sous l'effet de la température ou d'une décharge sous haute tension continue ou sous haute fréquence, et les procédés de dépôt sous ultravide par épitaxie par jets moléculaires et/ou par jets atomiques.

Les techniques de dépôt en solution comprennent les procédés de dépôt par réaction chimique et les procédés par électrolyse. La plupart de ces procédés permettent d'obtenir des couches polycristallines, compactes, dans de bonnes conditions mais ils sont mal adaptés à la réalisation de couches de composés de formule $C_mA_n$ dans laquelle A est un oxyanion ou un polyoxyanion. Par ailleurs, le contrôle de la stochiométrie du composé déposé et de l'épaisseur de la couche est difficile à effectuer. Enfin, le dépôt de couches monocristallines est pratiquement impossible à obtenir avec la plupart de ces procédés.

En effet, les procédés de dépôt sous vide par évaporation thermique ou par bombardement électronique sont difficiles à mettre en oeuvre et à contrôler car les composés de départ utilisés pour ce dépôt se décomposent partiellement ou totalement à chaud en éléments ayant des pressions de vapeur différentes. De ce fait, la stoechiométrie du composé déposé est souvent difficile à atteindre et l'épaisseur est difficile à contrôler, notamment sur de grandes surfaces. Dans la plupart des cas, on obtient un dépôt polycristallin présentant des porosités et des défauts. Par ailleurs, les procédés de dépôt sous vide ne peuvent être utilisés pour le dépôt de composés tels que les phosphates, les arséniates, les chromates et les carbonates.

Les procédés de dépôt chimique en phase vapeur (CVD) font intervenir des réactions chimiques ayant des équilibres thermodynamiques et des cinétiques compliqués, ce qui nécessite souvent la synthèse et la purification de composés organométalliques particuliers, souvent toxiques, inflammables et difficiles à manipuler. De plus, les produits secondaires de la réaction contaminent le dépôt, en particulier le

carbone, l'oxygène et les halogènes. Comme dans le cas du dépôt sous vide, l'épaisseur et l'homogénéité de l'épaisseur sont difficiles à contrôler car elles dépendent des cinétiques des réactions en surface et en volume, de l'homogénéité de température à des températures élevées et de l'hydrodynamique des gaz. Les couches obtenues, qui peuvent être amorphes ou polycristallines, présentent souvent une porosité et des couches épitaxiales ne peuvent être déposées que dans des conditions spéciales favorisant l'autocatalyse hétérogène en surface, ce qui nécessite généralement la mise en oeuvre d'un substrat chaud dans un tube froid, et pose des problèmes en ce qui concerne l'homogénéisation de température. De même, ces procédés ne conviennent pas pour le dépôt de composés de formule $C_mA_n$ dans laquelle A est un oxyanion ou un polyoxyanion.

Les procédés de dépôt sous ultravide par jets moléculaires permettent l'obtention de couches de bonne qualité cristalline, d'épaisseur et de stoechiométrie contrôlables, faciles à doper, mais la vitesse de croissance est faible et il est nécessaire d'utiliser un appareillage complexe et onéreux. Par ailleurs, ces procédés ne conviennent pas pour le dépôt de couches de composés comportant des oxyanions ou des polyoxyanions.

Les procédés de dépôt par réaction chimique en solution comme celui décrit dans le brevet français FR-A-2 138 410 qui fait appel à des réactions de double décomposition en solution, sont faciles à mettre en oeuvre entre la température ambiante et 100°C et extrêmement économiques. Le contrôle de l'épaisseur des couches est difficile à réaliser mais l'homogénéité est bonne, les couches obtenues sont stoechiométriques et leur dopage est facile. Cependant, ce procédé ne peut être mis en oeuvre qu'avec certains chalcogénures et certains métaux, car il est difficile de trouver des réactions chimiques hétérogènes lentes favorisant le dépôt en concurrence avec la réaction chimique homogène qui produit un précipité.

Les procédés par électrolyse ne peuvent être mis en oeuvre qu'avec des composés conducteurs comme le sulfure de nickel, le sulfure de cobalt ou des composés semiconducteurs comme le tellurure de cadmium. Le dépôt peut être obtenu par oxydation anodique, par réduction cathodique ou par codéposition cathodique mais l'épaisseur et la stoechiométrie des couches sont difficiles à contrôler. Par ailleurs, les couches présentent souvent des fissures, comportent des impuretés et l'on ne peut obtenir des couches monocristallines.

Ainsi, aucun des procédés connus ne peut conduire à l'obtention de couches monocristallines ou polycristallines de composés de type varié, en particulier de composés comportant des oxyanions ou des polyoxyanions.

La présente invention a précisément pour objet un procédé de dépôt de couches minces sur un substrat, facile à mettre en oeuvre, qui permet l'obtention de couches monocristallines ou polycristallines, compactes de composés stoechiométriques comportant notamment des oxyanions ou des polyoxyanions.

Le procédé, selon l'invention, de dépôt sur un substrat d'une couche mince d'un composé comportant au moins un constituant cationique C et au moins un constituant anionique A, consiste à former sur ledit substrat au moins deux couches ioniques superposées comportant respectivement le ou lesdits constituants cationiques C et le ou lesdits constituants anioniques A, par immersions successives dudit substrat dans au moins une première solution comportant au moins un

sel, un complexe ou un composé ionisé du ou desdits constituants cationiques C ou d'un précurseur du ou desdits constituants cationiques C, et dans au moins une deuxième solution comportant au moins un sel, un complexe ou un composé ionisé du ou desdits constituants anioniques A ou d'un précurseur du ou desdits constituants anioniques A, ledit substrat étant soumis à un rinçage par solvant entre deux immersions.

Dans ce procédé, la croissance de la couche mince du composé s'effectue par réaction chimique hétérogène à l'interface substrat-solution entre les cations C et les anions A adsorbés sur le substrat. En effet, lorsqu'on immerge le substrat dans la première solution qui contient par exemple un sel ionisé du constituant cationique C, il se forme sur le substrat une couche double électrique du type Helmholtz comprenant une couche cationique du constituant cationique C et une couche anionique de l'anion du sel présent dans la première solution.

La disposition des couches cationique et anionique par rapport au substrat dépend de la nature de celui-ci, et l'on peut avoir ainsi au contact du substrat soit la couche cationique, soit la couche anionique.

Après cette première immersion, on élimine, lors du rinçage, par convection et par diffusion, l'excès de solution qui adhère sur le substrat. Lorsqu'on immerge ensuite le substrat dans la deuxième solution, le constituant anionique A et le cation qui lui est associé dans la deuxième solution traversent la couche limite de solvant adhérente au substrat et pénètrent dans la couche d'Helmholtz. Il se produit à ce moment des échanges dans la couche d'Helmholtz dont la structure se modifie par réaction entre le constituant cationique C et le constituant anionique A ad-

sorbés, les constituants anioniques se déchargent et les atomes ainsi adsorbés qui viennent de réagir diffusent en surface et donnent naissance à des grains monocristallins qui viennent occuper leur site caractéristique dans le réseau du composé. Les partenaires cationique et anionique des constituants C et A sont repoussés par la croissance vers la partie diffuse de la couche double électrique et ils diffusent en partie vers la solution, ce qui permet de les éliminer lors de l'étape suivante de rinçage.

Selon un premier mode de réalisation du procédé de l'invention, celui-ci comprend au moins un cycle comprenant les étapes successives suivantes :

- immersion dudit substrat dans une première solution d'un sel, d'un complexe ou d'un composé ionisé dudit constituant cationique,
- rinçage dudit substrat par un solvant,
- immersion dudit substrat dans une deuxième solution d'un sel d'un composé ou d'un complexe ionisé dudit constituant anionique, et
- rinçage dudit substrat dans un solvant.

En répétant successivement ces cycles, on fait croître la couche du composé obtenu par réaction dudit constituant cationique C avec ledit constituant anionique A à partir des couches ioniques successives adsorbées sur le substrat.

Selon une variante de mise en oeuvre du procédé de l'invention, la formation des couches ioniques contenant le constituant cationique ou le constituant anionique est effectuée à partir d'un précurseur de ces constituants que l'on convertit ensuite en le constituant anionique ou en le constituant cationique par action d'un agent oxydant ou réducteur. Ainsi, dans le cas où l'on veut former la couche de constituant cationique à partir d'un précurseur de celui-ci,

on immerge tout d'abord le substrat dans une première solution d'un sel, d'un composé ou d'un complexe ionisé d'un précurseur dudit constituant cationique, on soumet ensuite le substrat à un rinçage par un solvant et on immerge enfin le substrat rincé dans une solution contenant un agent oxydant ou réducteur capable de convertir ledit précurseur en ledit constituant cationique.

L'agent oxydant peut être fourni par adsorption d'un hydroxyle et sa déprotonation par attachement à la surface du substrat.

Dans le cas où l'on veut apporter le constituant anionique à partir d'un précurseur, on immerge le substrat dans une deuxième solution d'un sel, d'un complexe, ou d'un composé ionisé d'un précurseur du constituant anionique, on rince ensuite le substrat par un solvant et on immerge le substrat rincé dans une solution contenant un agent oxydant ou réducteur capable de convertir ledit précurseur en ledit constituant anionique.

Le procédé de l'invention peut être mis en oeuvre pour la croissance d'une couche d'un composé ternaire ou quaternaire du type $C_mA_n$. Dans ce cas, on peut apporter l'autre constituant cationique et/ou l'autre constituant anionique dopant en les ajoutant respectivement à la première et à la deuxième solutions sous la forme de sel, de composé ou de complexe de ce constituant ou d'un précurseur de ce constituant. On peut aussi mettre en oeuvre périodiquement un cycle complémentaire consistant à former une couche ionique du constituant cationique ou anionique complémentaire de dopage par immersion du substrat dans une troisième solution d'un sel, d'un complexe ou d'un composé ionisé dudit dopant ou d'un agent précurseur dudit dopant. Dans ce dernier cas, le procédé peut

comprendre au moins un cycle complémentaire comprenant les étapes suivantes :

- immersion du substrat dans une troisième solution d'un sel, d'un complexe ou d'un composé ionisé d'un dopant cationique ou anionique, et
- rinçage dudit substrat par un solvant.

Selon une disposition avantageuse du procédé de l'invention qui s'applique uniquement dans le cas où le substrat et le composé à déposer sont conducteurs ou semiconducteurs de l'électricité, on peut augmenter le taux de recouvrement des sites de la couche en cours de croissance par le constituant anionique et/ou par le constituant cationique, en polarisant le substrat positivement par rapport à la solution lors de l'immersion de celui-ci dans la deuxième solution contenant le constituant anionique et en polarisant négativement le substrat par rapport à la solution lors de l'immersion du substrat dans la première solution. Lorsque le procédé comprend l'utilisation d'au moins une troisième solution pour le dépôt d'un dopant cationique et/ou le dépôt d'un dopant anionique, on peut de même polariser le substrat positivement ou négativement lors de l'immersion de celui-ci dans cette troisième solution, de façon à favoriser la formation et le recouvrement du substrat par le ou les couches ioniques de dopant. Dans tous les cas, la tension appliquée doit être inférieure à celle qui provoque la décomposition du sel, du complexe ou du composé présent dans la solution afin de ne pas provoquer une électrolyse de cette solution.

Selon l'invention, les concentrations en sel, en composé ou en complexe des solutions sont choisies en fonction de la vitesse de croissance que l'on veut obtenir. Ainsi, lorsque l'on utilise des solutions concentrées, le nombre d'immersions nécessai-

res pour obtenir l'épaisseur de couche voulue peut être moins important que dans le cas de solutions diluées, car l'on obtient, lors de chaque immersion, une occupation des sites par adsorption plus importante. Cependant, les couches polycristallines obtenues dans ce cas sont rugueuses, à gros grains et peu adhérentes. Lorsque l'on utilise des solutions plus diluées, il est nécessaire de réaliser un plus grand nombre d'immersions mais les couches polycristallines obtenues présentent de meilleures propriétés ; ainsi, elles sont à grains fins, compactes et adhérentes. Généralement, on utilise des concentrations en sel, en composé ou en complexe du ou desdits constituants cationiques ou anioniques ou d'un précurseur desdits constituants de l'ordre de $10^{-3}$ à 1 $mol.l^{-1}$.

Les durées d'immersion du substrat dans les solutions sont telles qu'on approche l'équilibre d'adsorption entre le substrat et la solution. Généralement, on utilise des durées de 5 à 120 s, et de préférence de l'ordre de 15 à 60 s.

La durée du rinçage est telle que l'on élimine complètement par convection et par diffusion l'excès de solution adhérent sur le substrat ainsi que les produits secondaires de la réaction, mais le rinçage ne doit par être excessif afin de ne pas trop perturber l'organisation de la couche double électrique formée sur le substrat lors de l'immersion dans la solution. La durée du rinçage varie de ce fait en fonction du débit du solvant des dimensions du substrat, du récipient utilisé pour le rinçage et de la nature du substrat et des solutions.

Généralement, on réalise le rinçage pendant une durée telle que le solvant qui s'écoule en fin de rinçage présente la même résistivité que le solvant introduit pour le rinçage. En effet, la résistivité du

solvant chute au début du rinçage puis revient ensuite à la valeur de départ qui est avantageusement d'environ 16 M$\Omega$.cm.

Plus précisément la durée du rinçage après l'immersion dans la solution contenant le sel du cation du composé est conditionnée par le temps nécessaire à la diffusion du sel du cation à travers la couche limite de solvant (dite de diffusion) adhérente au substrat. La concentration résiduelle admissible du cation dans cette couche $[C]_r$ doit satisfaire la relation

$$[C]_r^n < \frac{SpCmAn}{[A]^m}$$

où SpCmAn est le produit de solubilité du composé à déposer et $[A]$ est la concentration de l'anion du composé dans la solution du sel d'anion.

La même condition doit être observée pour la concentration résiduelle de l'anion du composé $[A]_r$

$$[A]_r^m < \frac{SpCmAn}{[C]^n}$$

pour empêcher la précipitation du composé dans la couche limite de solvant au moment des trempes.

A titre d'exemple, la durée du rinçage est généralement de 60 à 120 s.

Lorsque l'on utilise des durées d'immersion et des durées de rinçage dans la gamme indiquée ci-dessus, avec des solutions présentant les concentrations indiquées ci-dessus, on obtient une vitesse de croissance qui reste inférieure à 0,1 µm/h. Ainsi, le procédé de l'invention ne permet pas d'atteindre des vitesses de croissance élevées, mais pourtant il se prête très bien à l'industrialisation puisqu'en aug-

mentant les dimensions des substrats, on peut atteindre des vitesses de croissance rapportées à l'unité de surface des substrats comparables à celles obtenues avec d'autres procédés.

Les substrats utilisés dans le procédé de l'invention peuvent être de n'importe quel type à condition qu'ils ne soient pas solubles ou dégradables dans les solvants et les solutions utilisées. Toutefois, l'adhérence de la couche dépend de la nature du substrat et du composé à déposer, du traitement de surface du substrat avant le dépôt et éventuellement de traitements complémentaires qui peuvent être réalisés après le dépôt.

A titre d'exemple de substrats susceptibles d'être utilisés, on peut citer les substrats en verre, les substrats métalliques, par exemple en Mo, W, Ti ou Ni, les substrats plastiques par exemple en polyacrylates, polycarbonates, polyamides ou polyvinyliques, les substrats monocristallins métalliques par exemple en Zn ou Cd, les substrats monocristallins semiconducteurs par exemple en Ge, GaAs ou InP, et les substrats monocristallins diélectriques par exemple en $SiO_2$, $Al_2O_3$, $TiO_2$ ou $LiNbO_3$.

Lorsqu'on veut obtenir des couches monocristallines du composé on utilise un substrat réalisé en ce composé et présentant une orientation déterminée.

Les solutions utilisées pour la formation des couches ioniques sont de préférence des solutions aqueuses dans lesquelles les sels, complexes ou composés sont dissociés en ions. Pour le rinçage on utilise avantageusement de l'eau ayant de préférence une résistivité d'au moins 16 MΩ-cm, mais d'autres solvants peuvent être utilisés, aussi bien pour le rinçage, que pour la formation des solutions contenant les constituants cationiques et anioniques ou les précurseurs de ces constituants.

Ainsi, on peut utiliser des solvants organiques ou des mélanges d'eau et de solvant organique, à condition bien entendu que pour les opérations de formation des couches ioniques, les sels composés ou complexes présents dans ces solutions puissent être à l'état dissocié. Lorsque les solutions contiennent plusieurs constituants cationiques ou plusieurs constituants anioniques, les concentrations de ces différents constituants sont choisies en fonction de la composition de la couche à déposer. Dans les solutions, les constituants cationiques ou anioniques peuvent être présents sous la forme de complexe avec un ligand convenable, soluble dans la solution. Ce ligand peut être par exemple l'ammoniaque. Dans ces solutions, les partenaires anioniques ou cationiques des sels ou des complexes sont choisis de façon à favoriser la formation du composé $C_mA_n$ par réaction de double décomposition.

Le pH des solutions est ajusté au moyen d'un acide ou d'une base dans le domaine de pH à l'intérieur duquel seul le composé à déposer précipite par mélange des deux solutions, tandis que les sels, composés ou complexes présents dans chaque solution restent solubles dans ces solutions.

Le procédé de l'invention peut être mis en oeuvre pour le dépôt de composés de type $C_mA_n$ variés et s'applique en particulier à des composés dans lesquels l'anion A est un oxyanion ou un polyoxyanion. A titre d'exemple de composés de ce type susceptibles

d'être déposés par le procédé de l'invention, on peut citer les chalcogénures, les oxydes, les hydroxydes, les phosphates, les chromates, les molybdates, les titanates, les vanadates, les tungstates, les silicates, les carbonates et les oxalates métalliques.

Ainsi, le procédé de l'invention est particulièrement intéressant car il s'applique à de nombreux composés, ce qui n'était pas le cas des procédés de l'art antérieur.

Par ailleurs, il permet l'obtention de composés stoechiométriques, et les couches obtenues sont compactes et ne présentent pas de porosité. Elles peuvent être monocristallines ou polycristallines selon la nature du substrat utilisé, être dopées uniformément, avoir des épaisseurs allant de 100 à 20 000 Å à 1 ou 10% près avec une homogénéité d'épaisseur dans la limite de 1 à 10% de tolérance, et présenter des gros grains allant par exemple jusqu'à 0,5 µm pour des couches de 0,5 µm déposées sur du verre.

Ce procédé peut être utilisé avec des substrats de grande surface, de l'ordre de 10 à 1000 $cm^2$ car la surface est limitée uniquement par le volume de l'appareillage, c'est-à-dire des récipients contenant les solutions et l'eau de rinçage. Les substrats peuvent avoir de plus une forme quelconque du moment qu'il est possible de les rincer dans de bonnes conditions.

Le procédé de l'invention est facile à mettre en oeuvre car il ne nécessite ni chauffage ni appareillage complexe. De plus, on peut opérer à la température ambiante sous la pression atmosphérique. Il s'applique au dépôt de composés dopés uniformément par un cation ou un anion, de composés constitués par des solutions solides ternaires ou quaternaires, des

solutions solides de composés présentant des lacunes de solubilité à l'intérieur du domaine d'immiscibilité, des solutions solides de composés présentant une solubilité limitée au-delà de leur solubilité réciproque et des solutions solides de composés totalement insolubles. En effet, ceci peut être obtenu en introduisant des cations et/ou des anions supplémentaires dans les différentes solutions ou en réalisant des cycles complémentaires d'immersion du substrat dans une solution contenant le cation ou les cations et/ou dans une solution contenant l'anion et/ou les anions qui sont à ajouter.

On peut aussi obtenir par le procédé de l'invention des super-réseaux en introduisant l'élément dopant à certains moments afin d'obtenir une constante de mailles nd où d est la distance interréticulaire du composé dans la direction de croissance et n représente le nombre d'immersions réalisées avant le cycle complémentaire d'introduction de l'élément dopant.

On peut encore obtenir une structure multicouche épaisse en effectuant des séries successives de cycles d'immersion dans des solutions différentes, chaque série permettant de déposer une couche de la structure multicouche désirée.

En choisissant de façon appropriée le substrat, par exemple en utilisant un substrat monocristallin de même nature que le composé et en respectant les conditions d'orientation particulières du composé, on peut déposer par le procédé de l'invention une couche homoépitaxiale. En revanche, on dépose une couche hétéroépitaxiale lorsqu'on utilise un substrat de nature différente mais qui présente un accord de maille cristalline avec celui du composé à déposer, ainsi qu'une orientation convenable et une surface

propre susceptible d'être conservée dans les solutions. Lorsque le substrat est polycristallin ou amorphe, on obtient une couche polycristalline.

L'invention a également pour objet un dispositif de dépôt d'une couche mince sur un substrat par immersions successives du substrat dans différentes solutions, qui se caractérise en ce qu'il comprend :

- un plateau supportant une pluralité de récipients destinés à contenir lesdites solutions,
- des moyens pour supporter une pluralité de substrats à revêtir, lesdits moyens étant agencés par rapport audit plateau de façon telle que par déplacement en translation et/ou en rotation desdits moyens de support et/ou dudit plateau, chacun des substrats à revêtir soit immergé dans l'un desdits récipients, et
- des moyens pour déplacer en translation et/ou en rotation lesdits moyens de support et/ou ledit plateau.

Ce dispositif est particulièrement adapté à la mise en oeuvre du procédé de l'invention, car il permet de traiter simultanément plusieurs substrats. En effet, en déplaçant en translation le plateau ou les moyens de support, on peut réaliser l'immersion des substrats dans les récipients et après avoir déplacé en translation et/ou rotation les moyens de support et/ou le plateau, on peut poursuivre le traitement dans un autre récipient.

De préférence, le plateau est fixe et les moyens de support sont constitués par un arbre mobile en translation et en rotation, muni de moyens de fixation pour chacun desdits substrats. Généralement, l'arbre est vertical et il comporte plusieurs bras horizontaux en étoile aux extrémités desquels sont suspendus les substrats.

Dans ce cas, le plateau est circulaire et les récipients sont disposés en cercle sur le plateau, un récipient sur deux étant utilisé comme récipient de rinçage afin que chaque récipient contenant une solution soit entouré par deux récipients de rinçage, le nombre de récipients étant ainsi un nombre pair.

De préférence, le dispositif comprend de plus :

- un couvercle capable de s'adapter au-dessus dudit plateau de façon à former avec celui-ci une enceinte étanche contenant les substrats et lesdits récipients, et
- des moyens pour mettre en circulation un gaz inerte dans ladite enceinte, ce qui permet de réaliser le dépôt sous atmosphère contrôlée.

Le gaz inerte peut être en particulier de l'azote ou de l'argon.

Les récipients destinés au rinçage sont généralement munis de moyens pour mettre en circulation dans lesdits récipients un solvant de rinçage. Leur forme est de préférence adaptée à celle des substrats à traiter de façon à faire circuler le solvant en régime laminaire à l'intérieur des récipients, de préférence du bas vers le haut. Le solvant ayant servi au rinçage peut être ensuite purifié avant d'être recyclé pour une nouvelle opération de rinçage.

Avantageusement, le dispositif comprend aussi des moyens pour mesurer le degré de pureté du solvant de rinçage, ces moyens étant constitués par des cellules de mesure de conductivité et par des électrodes spécifiques pour la mesure des concentrations résiduelles de l'anion et du cation du composé. On peut aussi déterminer le pH à l'intérieur des récipients en disposant dans ceux-ci une électrode de référence à calomel ou une électrode à membrane de

verre. On peut déterminer la concentration de l'anion et du cation du composé en disposant à l'intérieur des récipients des électrodes de mesure spécifiques.

Le dispositif peut aussi comprendre de plus des moyens pour polariser positivement ou négativement lesdits substrats lorsqu'ils sont immergés dans certains desdits récipients.

D'autres caractéristiques et avantages de l'invention apparaîtront mieux à la lecture de la description qui suit donnée bien entendu à titre illustratif et non limitatif en référence au dessin annexé sur lequel :

- la figure 1 représente en coupe verticale le dispositif de l'invention, et
- les figures 2, 3 et 4 représentent schématiquement la formation de la couche du composé à partir des couches ioniques formées successivement sur le substrat.

Sur la figure 1, on voit que le dispositif comprend un plateau circulaire fixe 1 sur lequel sont disposés 2n récipients constitués alternativement par des récipients 3, 3' aptes à recevoir les solutions aqueuses de sel, de complexe ou de composé des constituants cationiques ou anioniques, et des récipients 5 constituant des récipients de rinçage. Un arbre 7 mobile en translation et en rotation par rapport au plateau 1 comprend deux bras horizontaux 9 disposés en étoile, à l'extrémité desquels sont suspendus les substrats 11 à revêtir. Un couvercle 13 peut être adapté sur le plateau 1 et présente une forme telle qu'il forme avec l'ensemble 1 une enceinte étanche contenant les récipients 3, 3' et 5, l'arbre 7 et les bras 9 supportant les substrats 11. Des moyens non représentés sur le dessin permettent de faire circuler un courant de gaz inerte à l'intérieur de l'enceinte,

ce gaz étant introduit par la conduite 15 et évacué par la conduite 17 et/ou par les conduites 23.

Comme on peut le voir sur le dessin, les récipients de rinçage 5 sont munis intérieurement de bacs 19 ayant une forme adaptée à celle du substrat à traiter qui, dans cet exemple, est un substrat rectangulaire. Aussi, les bacs 19 ont une forme parallélépipédique de section rectangulaire et d'épaisseur légèrement supérieure à celle des substrats à revêtir de façon à pouvoir faire écouler l'eau dans ces bacs en régime laminaire. L'eau est introduite par des conduites 21 munies de débitmètres (non représentés) à la base des bacs de rinçage et elle est évacuée par des conduites 23. A sa sortie, l'eau est purifiée avant d'être recyclée dans les conduites 21. Des cellules de mesure de conductivité sont intercalées sur les conduites 23 afin de mesurer la conductivité de l'eau quittant les bacs de rinçage 19 avant son introduction dans la station de purification. On peut aussi disposer dans ces conduits des électrodes spécifiques. A l'intérieur des récipients 3 et 3' contenant les solutions utilisées pour le dépôt, on peut immerger des électrodes de référence à calomel ou à membrane de verre pour mesurer le pH, ainsi que des électrodes spécifiques.

Des contacts électriques coulissants montés sur l'arbre 7 permettent de relier chaque substrat 11 à une source de courant électrique, si on le désire. Ainsi, par l'intermédiaire de ces contacts électriques et des électrodes de référence, on peut polariser les substrats par rapport aux solutions contenues dans les récipients 3 et 3' lorsque les substrats et le composé à déposer sont conducteurs ou semiconducteurs de l'électricité.

Le dispositif peut être commandé par un programmateur électronique qui permet de commander un cycle répétitif d'immersions et de rinçages des substrats, c'est-à-dire de commander le passage des substrats successivement dans les récipients 3, 5 et 3' avec des temps de résidence déterminés dans chacun des récipients.

A titre d'exemple, on a réalisé un dispositif de ce type en polychlorure de vinyle en utilisant des récipients 3, 3' et 5 en polypropylène d'un volume de 250 ml, les bacs de rinçage 19 ayant une section rectangulaire de 20 sur 50 mm et une hauteur de 70 mm. L'arbre est en acier inoxydable de 10 mm de diamètre et il coulisse à l'intérieur d'un palier étanche en polytétrafluoroéthylène, en étant actionné en translation par un moteur pas à pas 25 capable d'imprimer un mouvement de translation à la plaque 26 supportant l'arbre, par l'intermédiaire d'une vis à billes et de deux rails d'acier inox de 10 mm de diamètre servant comme guide de déplacement pour des douilles à billes de précision. Le mouvement de rotation de l'arbre est imprimé par un autre moteur pas à pas 27. Des fourches optiques servent comme limiteur de fin de course, la course verticale de l'arbre pouvant être par exemple de 100 mm, la vitesse de rotation de l'arbre étant de 0,1 rotation par s et la vitesse de translation de 2 cm/s. Le diamètre de l'appareillage est de 400 mm et la hauteur totale de 500 mm et il permet de traiter au maximum 4 substrats à la fois ayant au maximum chacun une surface de 75x40 mm.

Les exemples suivants sont donnés à titre non limitatif pour illustrer l'invention.

EXEMPLE 1

Cet exemple illustre l'utilisation du dispositif décrit ci-dessus pour le dépôt d'une couche de sulfure de zinc sur des substrats en verre constitués

par des lames de verre de microscope de 26 x 76 mm.

Dans ce cas, on utilise comme première solution pour la formation de la couche ionique contenant le zinc, une solution aqueuse de sulfate de zinc à 0,005 $mol.l^{-1}$ et à pH 3,9 ; comme deuxième solution pour la formation de la couche contenant S, on utilise une solution aqueuse de $Na_2S$ à 0,005 $mol.l^{-1}$ et pH 11,6. Dans les bacs de rinçage, on fait circuler de l'eau désionisée ayant une résistivité de 16 M$\Omega$.cm.

Les surfaces des lames de verre sont tout d'abord nettoyées en utilisant un agent nettoyant tel que celui commercialisé sous le nom Decon 90 par Prolabo et un appareil à ultrasons. Les lames sont ensuite attachées sur les bras 9 de l'arbre 7. On introduit alors dans les deux récipients 3, situés à gauche des bacs de rinçage 5, la solution de sulfate de zinc et dans les récipients 3' situés à droite des bacs de rinçage 5, la solution de sulfure de sodium. On ferme alors le couvercle 13 et on fait circuler dans le dispositif de l'azote. On immerge alors les substrats dans les récipients 3 ou 3' contenant les solutions de sulfate de zinc ou de sulfure de sodium et on les y maintient pendant 40 s. Après 40s, par un mouvement de translation et de rotation de l'arbre 7, on plonge les substrats dans les récipients de rinçage 5 en réglant le temps de rinçage et les débits d'eau de rinçage de sorte qu'à la fin du rinçage, l'eau de rinçage qui sort du bac 19 ait une résistivité de 16 M$\Omega$.cm et les concentrations résiduelles d'anion et du cation du composé dans la couche limite d'eau adhérente au substrat ne conduisent pas à la précipitation du composé dans cette couche. Pour un débit d'eau de rinçage dans les bacs de rinçage 5 situés après les solutions de sulfate de zinc de 30 l/h et un débit d'eau de rinçage dans les bacs de rinçage situés après

les récipients contenant la solution de $Na_2S$ de 30 l/h, le temps de rinçage est de 80 s. Après ce rinçage, on déplace à nouveau l'arbre 7 en translation et en rotation pour introduire les substrats 11 dans les récipients 3 ou 3' et on les y maintient pendant 40 s. On continue ces opérations jusqu'à l'obtention de l'épaisseur de couche désirée. A chaque immersion, on dépose ainsi environ 0,6 Å de ZnS.

Les couches obtenues dans ces conditions qui correspondent à une vitesse de croissance de 0,0016 µm/h, sont des couches de sulfure de zinc stoechiométrique, de structure cubique, de haute résistivité, compactes, polycristallines, sans orientation préférentielle des grains et de qualité optique en ce qui concerne la brillance et la transparence.

Sur les figures 2, 3 et 4, on a représenté schématiquement la formation des couches ioniques et de la couche déposée à la suite de l'immersion des lames de verre 11 dans la solution de sulfate de zinc, puis dans la solution de sulfure de sodium.

Comme représenté sur la figure 2, lors de l'immersion du substrat 11, dans la solution de sulfate de zinc, il se forme sur le substrat une couche double électrique du type Helmholtz comprenant une couche $Zn^{2+}$ suivie d'une couche de $SO_4^{2-}$ et d'une couche diffuse de sulfate de zinc.

Lors du rinçage qui suit, la couche limite diffuse de sulfate de zinc est éliminée et l'on obtient comme représenté sur la figure 3, une couche double électrique formée d'une couche de $Zn^{2+}$ et d'une couche de $SO_4^{2-}$. Lors de l'immersion suivante dans la solution de sulfure de sodium, les ions $Na^+$ et $S^{2-}$ pénètrent dans la couche double ionique et par réaction dans la couche on a diffusion du sulfate de sodium en solution et formation d'une couche de sulfure

de zinc sur le substrat, comme cela est représenté sur la figure 3.

EXEMPLE 2

Cet exemple porte sur la réalisation de couches épitaxiales de CdS[001] sur des substrats monocristallins de InP[111] de 40 mm de diamètre.

Dans ce cas, on utilise comme première solution une solution aqueuse de sulfate de cadmium à 0,005 $mol.l^{-1}$ et à pH 2,8 ; comme deuxième solution, on utilise une solution aqueuse de $Na_2S$ à 0,005 $mol.l^{-1}$ et à pH 11,6. Pour le rinçage, on utilise de l'eau désionisée ayant une résistivité de 16 $M\Omega$.cm.

Les substrats monocristallins en InP qui ont une épaisseur de 1 mm sont tout d'abord rodés, polis et décapés avec une solution de Br-méthanol à 1%. Pour la croissance, on utilise le même dispositif que dans l'exemple 1 et on immerge les substrats monocristallins en InP dans les récipients 3 ou 3' pendant 40 secondes puis on les soumet à un rinçage comme dans l'exemple 1, pendant une durée de 80 secondes, en utilisant également un débit d'eau de rinçage de 30 l/h. Dans ces conditions, on obtient une vitesse de croissance de 0,3 Å /immersion de la face [0001] de CdS sur [111] InP et de 0,6 Å/ immersion pour la face $[000\bar{1}]$ du CdS sur $[\bar{1}\bar{1}\bar{1}]$ InP.

Dans ces conditions, la vitesse de croissance de la couche est de 0,0016 µm/h comme dans l'exemple 1.

EXEMPLE 3

Cet exemple porte sur le dépôt d'une couche de sulfure de zinc sur un substrat en verre identique à celui de l'exemple 1. Dans cet exemple, on réalise la croissance d'une couche de ZnS sur le substrat en verre dans les mêmes conditions que celles de l'exem-

$ZnSO_4$. On incorpore ainsi le manganèse dans la couche de ZnS sous forme de MnS, soit à partir du $MnSO_4$ par la réaction suivante de double échange :

$$MnSO_4 + Na_2S \longrightarrow MnS\downarrow + Na_2SO_4$$

soit à partir du $KMnO_4$ par la réaction d'oxydoréduction suivante en deux étapes :

$$2KMnO_4 + 3Na_2S + 4H_2O \longrightarrow 2MnO_2\downarrow + 3S + 2KOH + 6NaOH$$

$$MnO_2 + 2Na_2S + 2H_2O \longrightarrow MnS + S + 4NaOH$$

La première réaction d'oxydoréduction dépose du $MnO_2$ sur la couche de ZnS dans la solution de $ZnSO_4$+$KMnO_4$ ; la deuxième réaction d'oxydoréduction transforme le $MnO_2$ en MnS dans la solution de $Na_2S$. Le soufre se dissout dans la solution de $Na_2S$ pour former du $Na_2S_2$.

Lorsqu'on utilise $MnSO_4$ on introduit dans la solution de $ZnSO_4$ dix à cent fois plus de $MnSO_4$ que ne l'indique le rapport molaire Mn/Zn souhaité dans la couche de ZnS. Lorsqu'on utilise $KMnO_4$, on utilise dix à cent fois moins de $KMnO_4$ que ne l'indique le rapport molaire Mn/Zn souhaité. Les couches obtenues dans ces conditions présentent la luminescence caractéristique du $Mn^{2+}$ dans le jaune. La vitesse de croissance est du même ordre de grandeur que celle de l'exemple 3.

ple 1 jusqu'à l'obtention d'une couche d'environ 200 Å, ce qui permet d'obtenir un dépôt homogène et compact ayant une bonne adhérence sur le verre. Cependant, comme dans l'exemple 1, la vitesse de croissance est faible dans ces conditions. Aussi, une fois que le substrat est recouvert avec cette couche de 200 à 300 Å de ZnS, on poursuit la croissance en utilisant d'autres conditions de dépôt, soit une première solution aqueuse de sulfate de zinc ayant une concentration en sulfate de zinc de 2 $mol.l^{-1}$ et un pH de 5,5 et une deuxième solution de $Na_2S$ ayant une concentration en $Na_2S$ de 2 $mol.l^{-1}$. On poursuit alors la croissance de la couche de sulfure de zinc en opérant comme dans l'exemple 1, mais en utilisant des durées d'immersion du substrat dans la première et la deuxième solutions de 20 s et des durées de rinçage de 80 s avec des débits d'eau de 120 l/h. Dans ces conditions, à chaque immersion on dépose environ 2,5 Å de ZnS, ce qui donne une vitesse de croissance de 0,008 µm/h soit une vitesse deux fois supérieure à celle de l'exemple 1.

Si l'on remplace les bacs de rinçage fonctionnant en régime laminaire par des bacs à buses fonctionnant en régime turbulent avec un débit d'eau de 120 l/h, et des durées de rinçage de 20 s, on obtient une vitesse de croissance de 0,017 µm/h, soit une vitesse de croissance dix fois plus importante que celle de l'exemple 1.

EXEMPLE 4

Cet exemple illustre le dépôt d'une couche de ZnS dopé au Mn sur un substrat en verre. Dans cet exemple, on utilise le même substrat et le même mode opératoire que dans l'exemple 3, mis à part le fait qu'au moins l'une des deux solutions contient un composé de manganèse. On peut introduire le manganèse sous forme de $MnSO_4$ ou de $KMnO_4$ dans la solution de

## REVENDICATIONS

1. Procédé de dépôt sur un substrat d'une couche mince d'un composé comportant au moins un constituant cationique C et au moins un constituant anionique A, caractérisé en ce qu'il consiste à former sur ledit substrat au moins deux couches ioniques superposées comportant respectivement le ou lesdits constituants cationiques C et le ou lesdits constituants anioniques A, par immersion successives dudit substrat dans au moins une première solution comportant au moins un sel, un complexe ou un composé du ou desdits constituants cationiques ou d'un précurseur du ou desdits constituants cationiques, et dans au moins une deuxième solution comportant au moins un sel, un complexe ou un composé du ou desdits constituants anioniques ou d'un précurseur du ou desdits constituants anioniques, ledit substrat étant soumis à un rinçage par un solvant entre deux immersions.

2. Procédé selon la revendication 1, caractérisé en ce qu'il comprend au moins un cycle comprenant les étapes successives suivantes :

- immersion dudit substrat dans une première solution d'un sel, d'un complexe ou d'un composé ionisé dudit constituant cationique,
- rinçage dudit substrat par un solvant,
- immersion dudit substrat dans une deuxième solution d'un sel, d'un composé ou d'un complexe ionisé dudit constituant anionique, et
- rinçage dudit substrat dans un solvant.

3. Procédé selon la revendication 1, caractérisé en ce que l'on forme la couche ionique comportant ledit constituant cationique par immersions du substrat dans une première solution d'un sel, d'un

composé, ou d'un complexe ionisé d'un précurseur dudit constituant cationique, suivie d'un rinçage dudit substrat par un solvant et d'une immersion du substrat rincé dans une solution contenant un agent oxydant ou réducteur capable de convertir ledit précurseur en ledit constituant cationique.

4. Procédé selon l'une quelconque des revendications 1 et 3, caractérisé en ce que l'on forme la couche ionique dudit constituant anionique par immersion du substrat dans une deuxième solution d'un sel, d'un complexe ou d'un composé ionisé d'un précurseur dudit constituant anionique, suivi d'un rinçage dudit substrat par un solvant et d'une immersion du substrat rincé dans une solution contenant un agent oxydant ou réducteur capable de convertir ledit précurseur en ledit constituant anionique.

5. Procédé selon l'une quelconque des revendications 1 à 4, caractérisé en ce que la première solution contient un dopant cationique ou un précurseur d'un dopant cationique.

6. Procédé selon l'une quelconque des revendications 1 à 5, caractérisé en ce que la deuxième solution contient un dopant anionique ou un précurseur d'un dopant anionique.

7. Procédé selon l'une quelconque des revendications 1 à 4, caractérisé en ce que l'on forme de plus sur le substrat une couche ionique comportant un dopant anionique ou cationique par immersion du substrat dans une troisième solution d'un sel, d'un complexe ou d'un composé ionisé dudit dopant ou d'un précurseur dudit dopant.

8. Procédé selon la revendication 2, caractérisé en ce qu'il comprend au moins un autre cycle comprenant les étapes suivantes :

- immersion du substrat dans une troisième solution

d'un sel, d'un complexe ou d'un composé ionisé d'un dopant cationique ou anionique, et

- rinçage dudit substrat par un solvant.

9. Procédé selon l'une quelconque des revendications 1 à 8, caractérisé en ce que l'on polarise le substrat négativement lors de l'immersion dudit substrat dans la première solution et/ou lors de l'immersion du substrat dans la troisième solution lorsque celle-ci contient un dopant cationique ou un précurseur d'un dopant cationique.

10. Procédé selon l'une quelconque des revendications 1 à 9, caractérisé en ce que l'on polarise le substrat positivement lors de l'immersion dudit substrat dans la deuxième solution, et/ou lors de l'immersion du substrat dans la troisième solution lorsque celle-ci contient un dopant anionique ou un précurseur d'un dopant anionique.

11. Procédé selon l'une quelconque des revendications 1 à 10, caractérisé en ce que le solvant de rinçage est de l'eau.

12. Procédé selon l'une quelconque des revendications 1 à 11, caractérisé en ce que lesdites solutions sont des solutions aqueuses.

13. Procédé selon la revendication 12, caractérisé en ce que les concentrations desdites solutions en sel, en composé ou en complexe sont de $10^{-3}$ à 1 $mol.l^{-1}$.

14. Procédé selon l'une quelconque des revendications 1 à 13, caractérisé en ce que la durée d'immersion du substrat dans chacune desdites solutions est de 5 à 120s.

15. Procédé selon l'une quelconque des revendications 1 à 14, caractérisé en ce que la durée de chaque rinçage est de 60 à 120 s.

16. Procédé selon l'une quelconque des revendications 1 à 15, caractérisé en ce que le composé à déposer est choisi parmi les chalcogénures, les oxydes, les hydroxydes, les phosphates, les chromates, les molybdates, les titanates, les vanadates, les tungstates, les silicates, les carbonates et les oxalates métalliques.

17. Procédé selon l'une quelconque des revendications 1 à 16, caractérisé en ce que le substrat est réalisé en métal ou en matière plastique.

18. Procédé selon l'une quelconque des revendications 1 à 16 de dépôt de couches épitaxiales sur un substrat, caractérisé en ce que l'on utilise un substrat monocristallin réalisé en ledit composé et présentant une orientation déterminée.

19. Procédé selon l'une quelconque des revendications 1 à 16 de dépôt de couches épitaxiales sur un substrat, caractérisé en ce que l'on utilise un substrat monocristallin réalisé en un matériau différent du composé à déposer, mais présentant un accord de maille cristalline avec le composé à déposer.

20. Procédé selon la revendication 19, caractérisé en ce que le substrat monocristallin est réalisé en métal, en matériau semiconducteur ou en matériau diélectrique.

21. Dispositif de dépôt de couches minces sur un substrat par immersions successives du substrat dans différentes solutions, caractérisé en ce qu'il comprend :

- un plateau (1) supportant une pluralité de récipients (3, 3', 5) destinés à contenir lesdites solutions,
- des moyens (7, 9) pour supporter une pluralité de substrat (11) à revêtir, lesdits moyens étant agencés par rapport audit plateau de façon telle que par déplacement en translation et/ou en rotation desdits

moyens de support et/ou dudit plateau, chacun des substrats à revêtir soit immergé dans l'un desdits récipients, et

- des moyens (25, 27) pour déplacer en translation et/ou en rotation lesdits moyens de support et/ou ledit plateau.

22. Dispositif selon la revendication 21, caractérisé en ce que le plateau (1) est fixe et en ce que lesdits moyens de support sont constitués par un arbre mobile (7) en translation et en rotation muni de moyens de fixation (9) pour chacun desdits substrats.

23. Dispositif selon l'une quelconque des revendications 21 et 22, caractérisé en ce qu'il comprend :

- un couvercle (13) capable de s'adapter au-dessus dudit plateau de façon à former avec celui-ci une enceinte étanche contenant les substrats et lesdits récipients, et
- des moyens (15, 17) pour mettre en circulation un gaz inerte dans ladite enceinte.

24. Dispositif selon l'une quelconque des revendications 21 à 23, caractérisé en ce que le plateau (1) est circulaire et en ce que lesdits récipients sont disposés sur ledit plateau de façon à former un cercle, un récipient sur deux constituant un récipient de rinçage (5) et étant muni de moyens (21, 23) pour mettre en circulation dans ledit récipient un solvant de rinçage.

25. Dispositif selon l'une quelconque des revendications 21 à 24, caractérisé en ce qu'il comprend des moyens pour polariser positivement ou négativement lesdits substrats lorsqu'ils sont immergés dans certains desdits récipients.

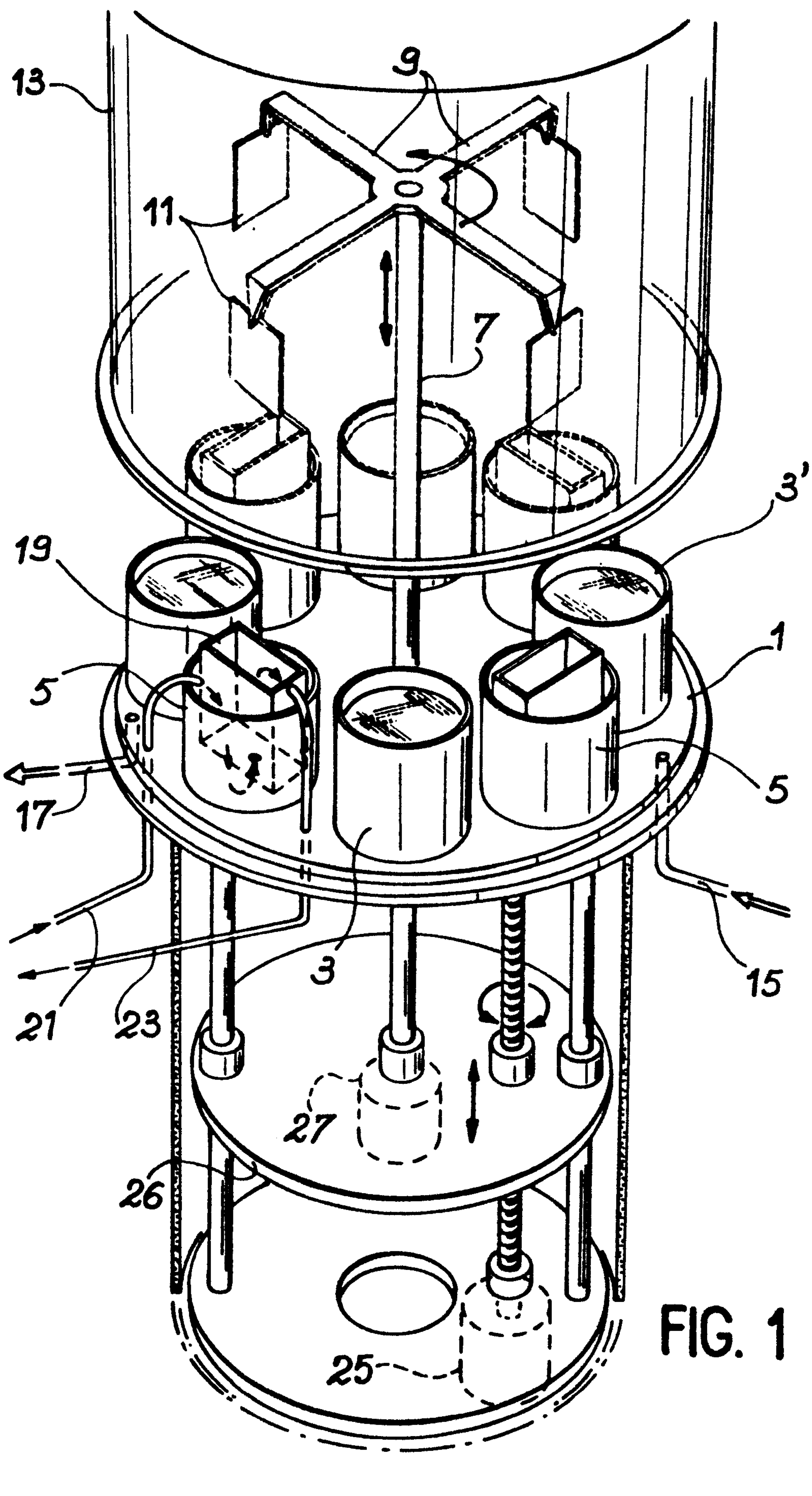


FIG. 1

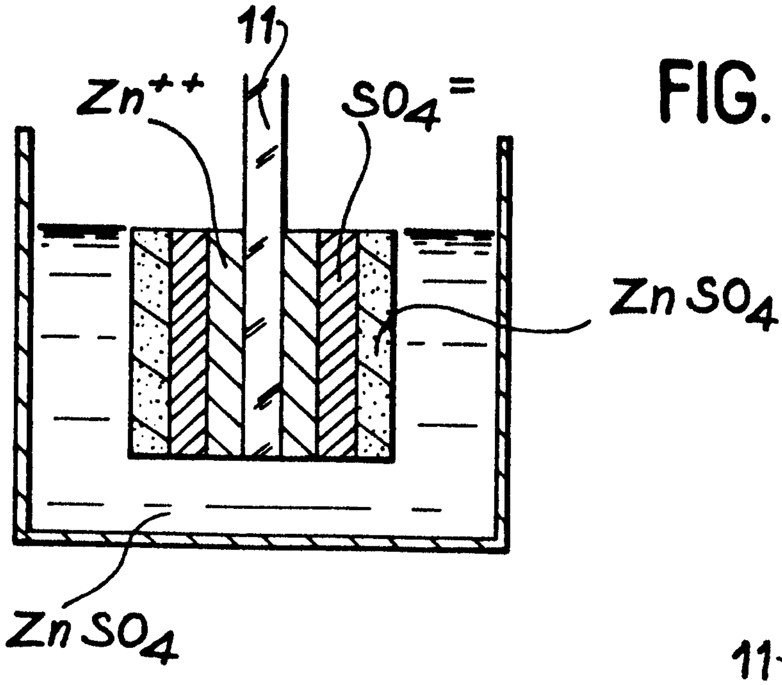


FIG. 2

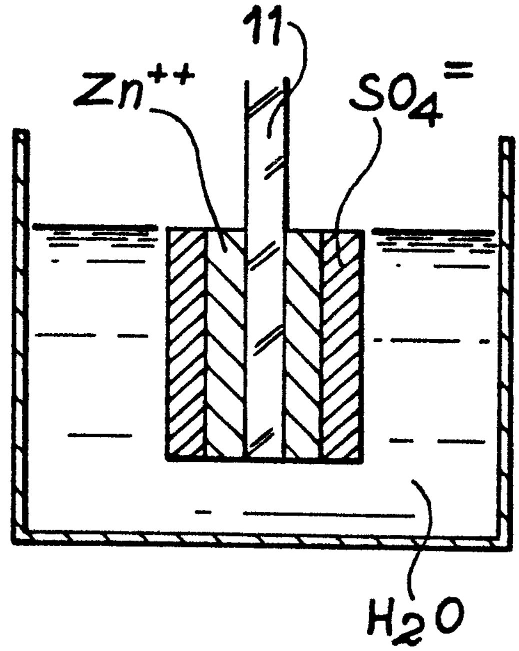


FIG. 3

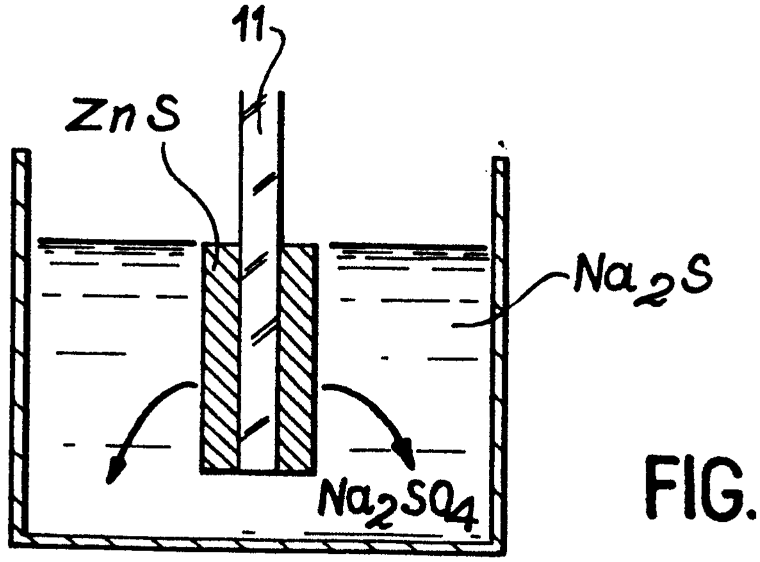


FIG. 4

0178955

Office européen des brevets

# RAPPORT DE RECHERCHE EUROPEENNE

Numero de la demande

EP 85 40 1632

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int Cl 4) |
|---|---|---|---|
| A | JOURNAL OF THE ELECTROCHEMICAL SOCIETY, vol. 124, no. 5, mai 1977, pages 743-748; N.R. PAVASKAR et al.: "Photoconductive CdS films by a chemical bath deposition process" |  | C 23 C 18/00<br>H 01 L 21/368 |
| A | US-A-3 466 190 (YAMASHITA) |  |  |
| A | US-A-4 061 830 (GREENBERG) |  |  |
|  |  |  | DOMAINES TECHNIQUES RECHERCHES (Int Cl 4) |
|  |  |  | C 23 C<br>C 01 G<br>H 01 L<br>C 01 B |

Le présent rapport de recherche a été établi pour toutes les revendications

| Lieu de la recherche | Date d'achèvement de la recherche | Examinateur |
|---|---|---|
| LA HAYE | 16-12-1985 | NGUYEN THE NGHIEP |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82